# EUROPÄISCHE PATENTSCHRIFT

(11) **EP 2 792 951 B1**
(45) Veröffentlichungstag und Bekanntmachung des Hinweises auf die Patenterteilung: **06.11.2019**
(21) Anmeldenummer: 14163989.8
(22) Anmeldetag: 09.04.2014
(51) Int. Cl.: F24C 7/08

(54) **Kochfeld**
Cooking top
Table de cuisson

(30) Priorität: 18.04.2013 ES 201330561
(43) Veröffentlichungstag der Anmeldung: 22.10.2014
(73) Patentinhaber: BSH Hausgeräte GmbH, 81739 München (DE)
(72) Erfinder: Alaman Aguilar, Jorge, 50008 Zaragoza (ES); Apetauer, Stefan, 80798 München (DE); Hackbarth, Andreas, 81479 München (DE); Heilmann, Tobias, 81371 München (DE); Rivera Peman, Julio, 50410 Cuarte de Huerva (Zaragoza) (ES)

(56) Entgegenhaltungen:
- EP-A1- 2 312 908
- EP-A2- 1 775 650
- EP-A2- 1 923 999
- WO-A1-2012/032432
- DE-A1- 19 906 365
- DE-A1-102004 005 952
- DE-A1-102011 077 168
- DE-B3-102004 013 947
- JP-A- S59 200 126
- JP-A- 2007 080 701

## Beschreibung

Die Erfindung geht aus von einem Kochfeld nach dem Oberbegriff des Anspruchs 1. Ein solches Kochfeld ist aus der DE 10 2004 013 947 B3 bekannt.

Es ist bereits eine Kochfeldbedienvorrichtung, mit zumindest einer Bedieneinheit, die zumindest eine Aufnehmerelektrode, die an einer Rückseite einer Platteneinheit angeordnet ist, und zumindest ein Sensorelement aufweist, das mit der Aufnehmerelektrode verbunden ist, vorgeschlagen worden.

Die Aufgabe der Erfindung besteht darin, ein gattungsgemäßes Kochfeld mit verbesserten Eigenschaften hinsichtlich einer hohen Flexibilität einer Bedienbarkeit bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einem Kochfeld mit einer Kochfeldbedienvorrichtung, mit zumindest einer Bedieneinheit, die zumindest eine Aufnehmerelektrode, die an einer Rückseite einer Platteneinheit angeordnet ist, und zumindest ein Sensorelement aufweist, das mit der Aufnehmerelektrode verbunden ist.

Es wird vorgeschlagen, dass die Bedieneinheit zumindest ein Bedienmittel aufweist, das dazu vorgesehen ist, an der Platteneinheit angeordnet zu sein und die Aufnehmerelektrode zu betätigen. Unter einer "Bedieneinheit" soll insbesondere eine Einheit verstanden werden, die zumindest eine Aufnehmerelektrode aufweist. Unter einer "Aufnehmerelektrode" soll insbesondere ein Element verstanden werden, das dazu vorgesehen ist, zumindest ein Signal aufzunehmen und das aufgenommene Signal an das Sensorelement weiterzuleiten. Das Signal ist als eine Kapazitätsänderung ausgebildet. Zusätzlich ist denkbar, dass die Aufnehmerelektrode als berührungsempfindliches Bedienelement ausgebildet ist. Unter einem "berührungsempfindlichen" Bedienelement soll insbesondere ein Bedienelement verstanden werden, das dazu vorgesehen ist, auf eine Berührung und/oder eine Annäherung durch einen Bediener, insbesondere eine Annäherung eines Körperteils, beispielsweise eines Fingers, eines Bedieners, insbesondere innerhalb eines Abstands von maximal 10 cm, insbesondere maximal 3 cm, vorteilhaft maximal 1 cm, vorzugsweise maximal 0,5 cm zu reagieren. Vorzugsweise reagiert das Bedienelement unabhängig von einer direkten Berührung und/oder Druckausübung, insbesondere durch eine Berührungsfläche hindurch auf eine Annäherung. Insbesondere ist die Berührungsfläche als eine Glas- und/oder Kunststoffeinheit und/oder eine Kochfeldplatte und/oder vorteilhaft als die Platteneinheit ausgebildet. Unter einem "Bedienelement" soll insbesondere ein Element verstanden werden, das dazu vorgesehen ist, bei einem Bedienvorgang eine Eingabegröße von einem Bediener aufzunehmen und insbesondere unmittelbar von einem Bediener kontaktiert zu werden, wobei ein Berühren des Bedienelements detektiert und/oder eine auf das Bedienelement ausgeübte Betätigungskraft detektiert und/oder mechanisch zur Betätigung eines Elements, insbesondere des Sensorelements, weiter geleitet wird. Die Bedieneinheit weist zumindest eine Steuereinheit auf, die dazu vorgesehen ist, in Abhängigkeit von einer Betätigung der Aufnehmerelektrode zumindest eine von dem Bediener durch die Betätigung der Aufnehmerelektrode gewünschte Aktion auszuführen. Insbesondere ist die Aktion als eine Auswahl und/oder Veränderung zumindest eines Betriebsparameters ausgebildet. Beispielsweise ist der Betriebsparameter als eine maximale Temperatur, als eine Warmhaltetemperatur, als eine Heizzone und/oder als eine Einstellung einer Heizleistungskenngröße der Heizzone ausgebildet. Insbesondere ist die Heizleistungskenngröße als eine Heizleistung und/oder eine Heizleistungsdichte ausgebildet. Alternativ sind weitere, einem Fachmann als sinnvoll erscheinende Betriebsparameter denkbar. Unter einer "Rückseite" der Platteneinheit ist eine in montiertem Zustand von einem Bediener abweisende Seite der Platteneinheit zu verstehen.

Unter einer "Platteneinheit" soll insbesondere eine Einheit verstanden werden, die eine Dicke aufweist, die wesentlich kleiner ist als eine Breite und/oder eine Länge der Einheit. Unter einer "Dicke" der Einheit soll insbesondere ein Minimum unter den maximalen Ausdehnungen der Einheit entlang beliebiger Raumrichtungen verstanden werden. Unter einer "maximalen Ausdehnung" einer Einheit entlang einer Raumrichtung soll insbesondere die maximale Länge aller Strecken verstanden werden, die zwei Randpunkte der Einheit verbinden und parallel zu der Raumrichtung verlaufen. Unter einer "Breite" und einer "Länge" der Einheit sollen insbesondere die maximalen Ausdehnungen der Einheit entlang von zwei Raumrichtungen verstanden werden, die zumindest im Wesentlichen senkrecht zueinander stehen und vorzugsweise zumindest im Wesentlichen senkrecht zu einer Raumrichtung stehen, entlang der die Einheit als maximale Ausdehnung die Dicke aufweist. Insbesondere sind Länge und Breite der Einheit die maximalen Ausdehnungen entlang von Raumrichtungen, für die die Summe der maximalen Ausdehnungen maximal ist. Insbesondere weist die Platteneinheit eine Dicke von mehr als 0,5 mm, insbesondere von mehr als 1 mm und vorteilhaft von mehr als 2 mm auf. Unter der Wendung, dass eine Gerade und/oder Ebene "zumindest im Wesentlichen senkrecht" zu einer weiteren, von der einen Gerade und/oder Ebene getrennt ausgebildeten Gerade und/oder Ebene ausgerichtet ist, soll insbesondere verstanden werden, dass die Gerade und/oder Ebene mit der weiteren Geraden und/oder Ebene bei einer Projektion auf zumindest eine Ebene einen Winkel einschließt, der vorzugsweise um weniger als 15°, vorteilhaft um weniger als 10° und insbesondere um weniger als 5° von einem Winkel von 90° abweicht. Unter der Wendung, dass die Aufnehmerelektrode an der Rückseite der Platteneinheit "angeordnet" ist, soll insbesondere verstanden werden, dass die Aufnehmerelektrode in einem Nahbereich der Rückseite positioniert ist. Unter einem "Nahbereich" der Rückseite der Platteneinheit soll insbesondere ein Bereich verstanden werden, der einen Abstand, der zumindest im Wesentlichen senkrecht zu der Rückseite ausgerichtet ist, von der Rückseite der Platteneinheit von weniger als 5 cm, insbesondere von weniger als 3 cm und vorteilhaft von weniger als 1 cm aufweist. Unter einem "Sensorelement" soll insbesondere ein Element verstanden werden, das dazu vorgesehen ist, zumindest eine Betätigung der mit dem Sensorelement verbundenen Aufnehmerelektrode zu detektieren. Das Sensorelement ist dazu vorgesehen, das bei Betätigung der mit dem Sensorelement verbundenen Aufnehmerelektrode detektierte Signal zumindest an die Steuereinheit zu übertragen. Unter der Wendung, dass das Sensorelement mit der Aufnehmerelektrode "verbunden" ist, soll insbesondere verstanden werden, dass das Sensorelement und die Aufnehmerelektrode in einem direkten, insbesondere elektrisch leitenden Kontakt miteinander angeordnet sind. Insbesondere weist die Bedieneinheit zumindest ein Leitungselement auf, das dazu vorgesehen ist, das Sensorelement und die Aufnehmerelektrode miteinander zu verbinden. Unter einem "Bedienmittel" soll insbesondere ein Element verstanden werden, das dazu vorgesehen ist, bei einem Bedienvorgang unmittelbar von einem Bediener kontaktiert zu werden. Insbesondere ist das Bedienmittel dazu vorgesehen, bei einem Bedienvorgang in Abhängigkeit von einer Kontaktierung durch den Bediener die Aufnehmerelektrode zu betätigen, insbesondere das mit der Aufnehmerelektrode verbundene Sensorelement auszulösen. Unter der Wendung, dass das Bedienmittel dazu vorgesehen ist, an der Platteneinheit "angeordnet" zu sein, soll insbesondere verstanden werden, dass sich das Bedienmittel in zumindest einem Betriebszustand in einem insbesondere direkten Kontakt mit der Platteneinheit befindet. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Durch die erfindungsgemäße Ausgestaltung kann insbesondere ein hohes Maß an Flexibilität bezüglich einer Bedienbarkeit erreicht werden. Insbesondere kann vorteilhaft die Aufnehmerelektrode flexibel mit einem Körperteil, insbesondere einem Finger, eines Bedieners und/oder mit dem Bedienmittel betätigt werden, wodurch zudem ein hoher Komfort erreicht werden kann. Durch eine Verwendung eines Bedienmittels zu einer Betätigung der Aufnehmerelektrode kann vorteilhaft eine neue Art einer Bedienung erreicht werden.

Das Sensorelement ist zu der Aufnehmerelektrode beabstandet angeordnet. Unter der Wendung, dass das Sensorelement zu der Aufnehmerelektrode "beabstandet" angeordnet ist, soll insbesondere verstanden werden, dass das Sensorelement und die Aufnehmerelektrode in einem Abstand von mehr als 1 cm, insbesondere von mehr als 2 cm und vorteilhaft von mehr als 5 cm angeordnet sind. Dadurch kann vorteilhaft eine Anordnung der Aufnehmerelektrode und des Sensorelements relativ zueinander flexibel gewählt werden.

Das Bedienmittel ist als ein Drehelement, insbesondere als ein Drehknebel und/oder ein Drehregler und/oder eine Disc, ausgebildet. Dadurch kann vorteilhaft eine einem Bediener vertraute Ausgestaltung eines Bedienmittels zu einer Kontaktierung der Aufnehmerelektrode verwendet werden.

Das Bedienmittel ist zumindest teilweise abnehmbar an der Platteneinheit angeordnet. Unter der Wendung, dass das Bedienmittel "zumindest teilweise abnehmbar" an der Platteneinheit angeordnet ist, soll insbesondere verstanden werden, dass das Bedienmittel zumindest ein Bedienerelement aufweist, das abnehmbar an der Platteneinheit angeordnet ist. Insbesondere ist das abnehmbare Bedienerelement in zumindest einem Betriebszustand zumindest mittels einer, insbesondere magnetischen, Haltekraft an der Platteneinheit befestigt. Ebenfalls denkbar sind weitere, einem Fachmann als sinnvoll erscheinende Befestigungsmöglichkeiten des abnehmbaren Elements an der Platteneinheit. Unter der Wendung, dass das Bedienmittel zumindest teilweise "abnehmbar" an der Platteneinheit angeordnet ist, soll insbesondere verstanden werden, dass das Bedienerelement des Bedienmittels von zumindest einem Bediener an der Platteneinheit angeordnet und/oder von der Platteneinheit entfernbar ist. Insbesondere ist das Bedienerelement mittels der Haltekraft an der Platteneinheit angeordnet. Dadurch kann vorteilhaft eine flexible Anordnung des Bedienmittels an der Platteneinheit erreicht werden.

Ferner wird vorgeschlagen, dass das Bedienmittel zumindest ein Betätigungselement zu einer Betätigung der Aufnehmerelektrode aufweist, das an der Rückseite der Platteneinheit angeordnet ist. Insbesondere sind das Betätigungselement und die Aufnehmerelektrode in zumindest einem Betriebszustand in einem Abstand von weniger als 3 cm, insbesondere von weniger als 1 cm und vorteilhaft von weniger als 0,5 cm relativ zueinander angeordnet. Dadurch kann vorteilhaft die Aufnehmerelektrode gezielt und zuverlässig betätigt werden.

Die Bedieneinheit weist eine Vielzahl, insbesondere mehr als drei, vorteilhaft mehr als neun, bevorzugt mehr als fünfzehn weiterer Aufnehmerelektroden auf, die zumindest im Wesentlichen in einer Linie angeordnet sind. Insbesondere weist die Bedieneinheit mehr als zwei, vorteilhaft mehr als vier, bevorzugt mehr als sieben und vorzugsweise eine Vielzahl weiterer Sensorelemente auf. Prinzipiell ist eine Anordnung der weiteren Sensorelemente beliebig. Vorteilhaft sind die Sensorelemente in einer Linie angeordnet, die insbesondere eine Reihe ausbildet. Unter der Wendung, dass die Aufnehmerelektroden "zumindest im Wesentlichen in einer Linie" angeordnet sind, soll insbesondere verstanden werden, dass zumindest eine kürzeste Verbindungslinie existiert, die die Mittelpunkte und/oder Schwerpunkte der Aufnehmerelektroden verbindet. Insbesondere weist die Verbindungslinie einen Krümmungsradius von mehr als 0,54 cm, insbesondere von mehr als 1 cm und vorteilhaft von mehr als 1,5 cm auf. Insbesondere weist die Verbindungslinie einen Krümmungsradius von weniger als 20 cm, insbesondere von weniger als 15 cm und vorteilhaft von weniger als 10 cm auf. Insbesondere existiert zumindest eine Bedienrichtung, die im Wesentlichen durch einen Verlauf der Verbindungslinie definiert ist. Insbesondere ist die Bedienrichtung in Richtung der Verbindungslinie ausgerichtet. Dadurch können die Aufnehmerelektroden vorteilhaft übersichtlich angeordnet werden, wodurch ein hoher Bedienkomfort erreicht werden kann. Weiterhin wird vorgeschlagen, dass die Linie zumindest im Wesentlichen ein Oval, insbesondere einen Kreis, ausbildet. Ebenfalls denkbar ist, dass die Linie zumindest im Wesentlichen eine Ellipse ausbildet. Zudem sind weitere, einem Fachmann als sinnvoll erscheinende Ausbildungen der Linie denkbar. Unter der Wendung, dass die Linie "zumindest im Wesentlichen einen Kreis ausbildet", soll insbesondere verstanden werden, dass die als Kreis ausgebildete Linie bei einer Betrachtung in zumindest einer Querschnittsebene eine Fläche eines kleinsten, die als Kreis ausgebildete Linie umschließenden Kreises zu einem Anteil von mehr als 70 %, insbesondere von mehr als 90 % und vorteilhaft von mehr als 95 % ausfüllt. Insbesondere füllt ein größter, innerhalb der als Kreis ausgebildeten Linie angeordneter Kreis bei der Betrachtung in der Querschnittsebene eine Fläche der als Kreis ausgebildeten Linie zu einem Anteil von mehr als 70 %, insbesondere von mehr als 90 % und vorteilhaft von mehr als 95 % aus. Dadurch kann vorteilhaft eine kompakte, symmetrische Anordnung der Aufnehmerelektroden erreicht werden. Insbesondere können derart angeordnete Aufnehmerelektroden vorteilhaft angenehm und zielsicher von dem Bedienmittel betätigt werden.

Die Aufnahmeelektroden sind als Beschichtung ausgebildet. Insbesondere ist die Beschichtung aus halbleitendem Material und/oder aus leitendem Material und/oder aus einer Kombination aus halbleitendem und leitendem Material ausgebildet. Insbesondere ist die Beschichtung aus lösungsmittelbasierender Tinte ausgebildet, die beispielsweise Anteile an Silber, Kupfer, Aluminium und/oder zumindest einer leitfähigen Keramik aufweist. Insbesondere ist eine Leitfähigkeit der Beschichtung durch eine Änderung einer Zusammensetzung der Anteile einstellbar. Beispielsweise könnte die Beschichtung durch Besputtern einer großen Fläche und anschließendem Entfernen unerwünschter Teilbereiche mittels Laser hergestellt sein. Unter einer "Beschichtung" soll eine insbesondere fest haftende Schicht aus einem Stoff verstanden werden, die auf eine Oberfläche zumindest eines Bauteils aufgebracht ist. Insbesondere weist die Beschichtung eine Materialstärke auf, die weniger als 10 %, vorzugsweise weniger als 5 % und insbesondere weniger als 1 % einer Materialstärke des Bauteils, auf dem die Beschichtung aufgebracht ist, beträgt. Insbesondere weist die Beschichtung eine zumindest im Wesentlichen gleich bleibende Materialstärke auf. Insbesondere weist die Beschichtung eine Materialstärke von weniger als 1 mm, insbesondere von weniger als 0,3 mm, vorteilhaft von weniger als 0,1 mm, bevorzugt von weniger als 0,03 mm und vorzugsweise von weniger als 0,01 mm auf. Unter einer "zumindest im Wesentlichen gleich bleibenden Materialstärke" soll insbesondere eine Materialstärke verstanden werden, deren Betrag sich im Bereich der Beschichtung des Bauteils um weniger als 20 %, insbesondere um weniger als 10 % und vorteilhaft um weniger als 5 % ändert. Dadurch kann vorteilhaft eine platzsparende Anordnung der Aufnehmerelektroden erreicht werden. Zudem kann vorteilhaft durch Verwendung bereits bekannter Techniken eine angenehm einfach zu bedienende, kostengünstige Hausgerätebedienvorrichtung erreicht werden, bei welcher insbesondere auf spezielle Hardware und/oder Sensoren für das Bedienmittel verzichtet werden kann.

Zudem wird vorgeschlagen, dass die Bedieneinheit zumindest ein Abschirmelement aufweist, das dazu vorgesehen ist, zumindest das Sensorelement abzuschirmen. Unter einem "Abschirmelement" soll insbesondere ein Element verstanden werden, das dazu vorgesehen ist, zumindest ein abzuschirmendes Element, insbesondere zumindest das Sensorelement, gegenüber einer Annäherung und/oder Berührung zumindest größtenteils abzuschirmen. Insbesondere ist das Abschirmelement dazu vorgesehen, zumindest eine wesentliche Beeinflussung eines von dem abzuschirmenden Element ausgehenden elektrischen Felds bei der Annäherung und/oder Berührung zu unterbinden. Insbesondere ist das Abschirmelement als ein von einer Elektronikplatine und/oder einer Kochfeldplatte und/oder der Platteneinheit differierendes Element ausgebildet. Insbesondere ist das Abschirmelement als ein elektrisch leitfähiges, geerdetes Bauteil ausgebildet, das in einer Umgebung des abzuschirmenden Elements angeordnet ist. Alternativ sind weitere, einem Fachmann als sinnvoll erscheinende Ausgestaltungen des Abschirmelements denkbar. Unter einer "wesentlichen Beeinflussung" des von dem Sensorelement ausgehenden elektrischen Felds soll insbesondere eine Änderung verstanden werden, die von der Steuereinheit der Bedieneinheit als ein auslösendes Ereignis interpretiert wird. Unter der Wendung, dass das Abschirmelement dazu vorgesehen ist, zumindest das Sensorelement "zumindest größtenteils" abzuschirmen, soll insbesondere verstanden werden, dass das Abschirmelement dazu vorgesehen ist, das Sensorelement über einen Anteil von mehr als 70 %, insbesondere von mehr als 80 % und vorteilhaft von mehr als 90 % eines Betrags einer Länge des Sensorelement abzuschirmen. Dadurch kann vorteilhaft eine ungewollte Betätigung des Sensorelements vermieden werden, wodurch eine funktionsfähige Hausgerätebedienvorrichtung erreicht werden kann.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
Fig. 1 ein erfindungsgemäßes Kochfeld mit einer Kochfeldbedienvorrichtung in einer schematischen Draufsicht und

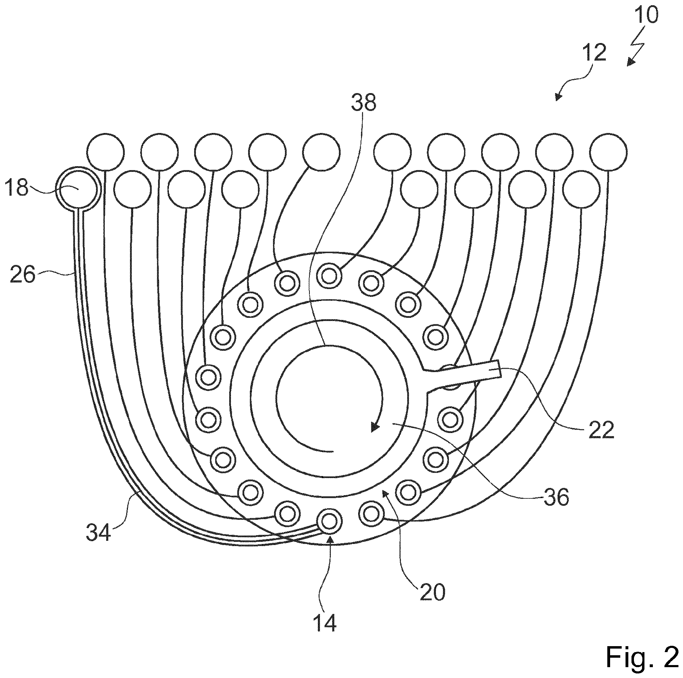

Fig. 2 die Kochfeldbedienvorrichtung aus Fig. 1 in einer vereinfachten, schematischen Draufsicht.

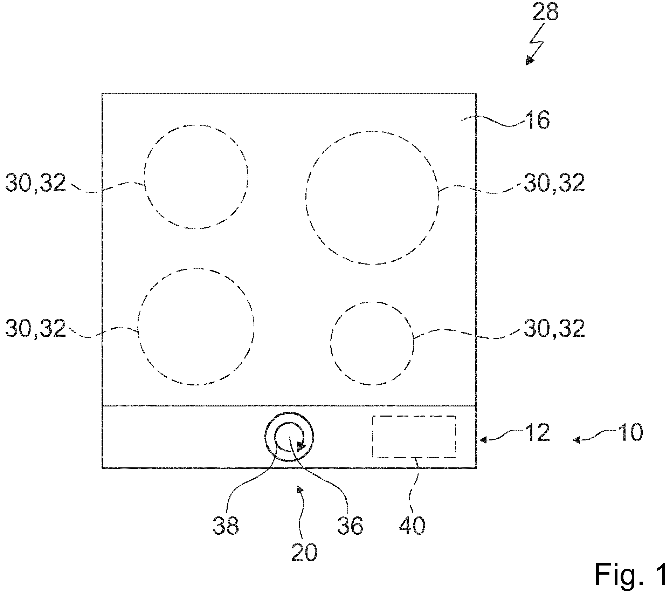

Fig. 1 zeigt ein erfindungsgemäßes Kochfeld 28 mit einer Kochfeldbedienvorrichtung 10. Das Kochfeld 28 weist eine als Kochfeldplatte ausgebildete Platteneinheit 16 zu einem Aufstellen von Gargeschirren auf. Zudem weist das Kochfeld 28 vier Heizeinheiten 30 auf, die unterhalb der Platteneinheit 16 angeordnet sind. Die Heizeinheiten 30, die als Induktionsheizeinheiten ausgebildet sind, sind jeweils dazu vorgesehen, ein auf der Platteneinheit 16 oberhalb einer der Heizeinheiten 30 aufgestelltes Gargeschirr zu erhitzen. Jeweils eine der Heizeinheiten 30 bildet jeweils eine eigenständige Heizzone 32 zu einem Erhitzen eines aufgestellten Gargeschirrs aus.

In einem in montiertem Zustand einem Bediener zuweisenden Bereich der Platteneinheit 16 weist das Kochfeld 28 die als Induktionskochfeldbedienvorrichtung ausgebildete Kochfeldbedienvorrichtung auf. Die Kochfeldbedienvorrichtung 10 weist eine Bedieneinheit 12 auf, die eine Vielzahl von Aufnehmerelektroden 14 aufweist. Hierbei weist die Bedieneinheit 12 achtzehn Aufnehmerelektroden 14 auf. Die Vielzahl an Aufnehmerelektroden 14 ist an einer Rückseite der Platteneinheit 16 angeordnet. Hierbei ist die Vielzahl an Aufnehmerelektroden 14 im Wesentlichen in einer Linie angeordnet, wobei die Linie ein im Wesentlichen als Kreis geformtes Oval ausbildet. Die Aufnehmerelektroden 14 sind gleichmäßig verteilt über die Linie angeordnet. Hierbei sind die Aufnehmerelektroden 14 gleichmäßig verteilt über den Kreis angeordnet. Die berührungsempfindlich ausgebildeten Aufnehmerelektroden 14 sind in Abhängigkeit von einer Betätigung der Aufnehmerelektroden 14 zu einer Aufnahme von Befehlen vorgesehen. Die Bedieneinheit 12 weist eine Steuereinheit 40 auf, die dazu vorgesehen ist, in Abhängigkeit von einer Betätigung der Aufnehmerelektroden 14 unterschiedliche Aktionen auszuführen.

Die Bedieneinheit 12 weist eine Vielzahl an Sensorelementen 18 auf, die jeweils einer der Aufnehmerelektroden 14 zugeordnet sind, wobei jeder der Aufnehmerelektroden 14 eines der Sensorelemente 18 zugeordnet ist. Hierbei weist die Bedieneinheit 12 achtzehn Sensorelemente 18 auf. Somit ist eine Anzahl an Sensorelementen 18 gleich einer Anzahl an Aufnehmerelektroden 14. Jeweils eines der Sensorelemente 18 ist mit einer jeweiligen der Aufnehmerelektroden 14 verbunden und zu der jeweiligen der Aufnehmerelektroden 14 beabstandet angeordnet. Die Bedieneinheit 12 weist eine Vielzahl an Leitungselementen 34 auf, wobei ein jeweiliges der Leitungselemente 34 ein jeweiliges der Sensorelemente 18 mit einer jeweiligen der Aufnehmerelektroden 14 verbindet. Insgesamt weist die Bedieneinheit 12 achtzehn Leitungselemente 34 auf. Von den Sensorelementen 18, den Aufnehmerelektroden 14 sowie den Leitungselementen 34 ist jeweils lediglich eines mit einem Bezugszeichen versehen. Die Bedieneinheit 12 weist eine Vielzahl an Abschirmelementen 26 auf, wobei ein jeweiliges der Abschirmelemente 26 dazu vorgesehen ist, ein jeweiliges der Sensorelemente 18 sowie ein jeweiliges der Leitungselemente 34 abzuschirmen. Hierbei weist die Bedieneinheit 12 achtzehn Abschirmelemente 26 auf. Von der Vielzahl an Abschirmelementen 26 ist der Übersichtlichkeit halber lediglich eines dargestellt. Analog zu den Aufnehmerelektroden 14 sind die Leitungselemente 34, die Abschirmelemente 26 sowie die Sensorelemente 18 jeweils auf der Rückseite der Platteneinheit 16 angeordnet. Die Leitungselemente 34, die Abschirmelemente 26 sowie die Aufnehmerelektroden 14 sind jeweils als Beschichtung ausgebildet. Hierbei ist die Beschichtung auf der Rückseite der Platteneinheit 16 aufgebracht. Im Folgenden wird lediglich eines der Sensorelemente 18, eine der Aufnehmerelektroden 14, eines der Leitungselemente 34 sowie eines der Abschirmelemente 26 beschrieben.

Die Bedieneinheit 12 weist ein Bedienmittel 20 auf, das dazu vorgesehen ist, an der Platteneinheit 16 angeordnet zu sein. Das Bedienmittel 20 ist in einem Betriebszustand in einem direkten Kontakt mit der Platteneinheit 16 angeordnet. Das Bedienmittel 20 ist als ein Drehelement ausgebildet. Ein Mittelpunkt des als Drehelement ausgebildeten Bedienmittels 20 ist im Wesentlichen identisch mit einem Mittelpunkt des Ovals, in dem die Aufnehmerelektroden 14 im Wesentlichen angeordnet sind. Das Bedienmittel 20 ist dazu vorgesehen, die Aufnehmerelektroden 14 zu betätigen. Hierbei ist das Bedienmittel 20 dazu vorgesehen, von einem Bediener zu einer Betätigung der Aufnehmerelektroden 14 verwendet zu werden.

Das Bedienmittel 20 weist ein Bedienerelement 36 zu einer direkten Kontaktierung durch einen Bediener sowie ein Betätigungselement 22 zu einer Betätigung der Aufnehmerelektroden 14 auf. Das Bedienerelement 36 ist auf einer in montiertem Zustand einem Bediener zuweisenden Oberseite der Platteneinheit 16 angeordnet. Das Betätigungselement 22 ist an der Rückseite der Platteneinheit 16 angeordnet. Das Betätigungselement 22 und das Bedienerelement 36 sind in montiertem Zustand aneinander befestigt, wobei das Betätigungselement 22 und das Bedienerelement 36 durch die Platteneinheit 16 hindurch aneinander befestigt sind. Hierzu weist das Bedienerelement 36 ein Haltemittel auf, das zusammen mit einem Haltemittel des Betätigungselements 22 eine Haltekraft erzeugt. Durch die derart erzeugte Haltekraft sind das Betätigungselement 22 und das Bedienerelement 36 aneinander gekoppelt. Zudem ist eine Bewegung des Betätigungselements 22 an eine Bewegung des Bedienerelements 36 gekoppelt. Hierbei sind das Betätigungselement 22 und das Bedienerelement 36 drehfest aneinander gekoppelt. Das Betätigungselement 22 und das Bedienerelement 36 sind über eine Verbindung aneinander gekoppelt, die über eine vollständige Umdrehung gemittelt einen Leistungsfluss mit einem unveränderten Drehmoment, einer unveränderten Drehrichtung und/oder einer unveränderten Drehzahl überträgt. Die jeweiligen Haltemittel sind im Wesentlichen in dem Mittelpunkt des Bedienmittels 20 angeordnet. Beispielsweise sind die beiden Haltemittel jeweils als ein Magnet, wobei einander zuweisende Seiten der Haltemittel eine differierende Polarität aufweisen, und die Haltekraft als eine magnetische Haltekraft ausgebildet. Alternativ sind weitere, einem Fachmann als sinnvoll erscheinende Ausbildungen der Haltemittel sowie der Haltekraft denkbar.

Das Bedienmittel 20 ist teilweise abnehmbar an der Platteneinheit 16 angeordnet. Hierbei ist das Bedienerelement 36 abnehmbar von der Oberseite der Platteneinheit 16 an der Platteneinheit 16 angeordnet. Durch eine Überwindung der Haltekraft ist eine Abnahme des Bedienerelements 36 von der Oberseite der Platteneinheit 16 ermöglicht. Bei einer Abnahme des Bedienerelements 36 von der Platteneinheit 16 verbleibt das Betätigungselement 22 in einer Position an der Rückseite der Platteneinheit 16. Alternativ ist denkbar, dass das Betätigungselement 22 sich aufgrund einer rücktreibenden Kraft in eine Ausgangsposition zurückdreht. Im vorliegenden Ausführungsbeispiel ist das Bedienerelement 36 aus Kunststoff ausgebildet. Alternativ könnte das Bedienerelement 36 aus Metall ausgebildet sein. Das Betätigungselement 22 ist aus Metall ausgebildet. Ebenfalls denkbar sind weitere, einem Fachmann als sinnvoll erscheinende Ausbildungen und Materialien des Bedienerelements 36 sowie des Betätigungselements 22.

In einem Verfahren zum Betrieb der Hausgerätebedienvorrichtung 10 wird in einem ersten Verfahrensschritt das Bedienerelement 36 des Bedienmittels 20 an der Platteneinheit 16 angeordnet. Hierbei erzeugen das Bedienerelement 36 und das Betätigungselement 22 mittels der Haltemittel eine Haltekraft, die das Bedienerelement 36 und das Betätigungselement 22 aneinander koppelt. Wird das Bedienerelement 36 von einem Bediener in oder entgegen einer Bedienrichtung 38 bewegt, so wird aufgrund der drehfesten Kopplung mittels der Haltekraft im Wesentlichen zeitgleich das Betätigungselement 22 entsprechend in oder entgegen der Bedienrichtung 38 bewegt. Das Betätigungselement 22, das an der Rückseite der Platteneinheit 16 in einem direkten Kontakt mit den Aufnehmerelektroden 14 angeordnet ist, betätigt in Abhängigkeit von der Bedienrichtung 38 entsprechende Aufnehmerelektroden 14. Daraufhin wird jeweils ein mit einer betätigten Aufnehmerelektrode 14 verbundenes Sensorelement 18 ausgelöst. Hierdurch wird ein Bediensignal erzeugt, in Abhängigkeit dessen die Steuereinheit 40 eine Aktion ausführt. Alternativ zu einer Betätigung der Aufnehmerelektroden 14 mittels des Bedienmittels 20 ist eine Betätigung mittels eines Körperteils, wie beispielsweise einem Finger, möglich. Durch eine derartige Ausgestaltung hat ein Bediener die Möglichkeit zu entscheiden, ob er die Aufnehmerelektroden 14 mittels seines Fingers oder mittels des Bedienmittels 20 betätigen will. Alternativ zu den oben beschriebenen Sensorelementen 18 könnten konventionelle Sensoren verwendet werden.

### Bezugszeichen

- 10: Hausgerätebedienvorrichtung
- 12: Bedieneinheit
- 14: Aufnehmerelektrode
- 16: Platteneinheit
- 18: Sensorelement
- 20: Bedienmittel
- 22: Betätigungselement
- 26: Abschirmelement
- 28: Hausgerät
- 30: Heizeinheit
- 32: Heizzone
- 34: Leitungselement
- 36: Bedienerelement
- 38: Bedienrichtung
- 40: Steuereinheit

## Patentansprüche

1. Kochfeld mit einer als Kochfeldplatte ausgebildeten Platteneinheit (16) zu einem Aufstellen von Gargeschirren und mit zumindest einer Kochfeldbedienvorrichtung, welche zumindest eine Bedieneinheit (12) aufweist, die zumindest eine Aufnehmerelektrode (14), die an einer Rückseite der Platteneinheit (16) angeordnet ist, und zumindest ein Sensorelement (18) aufweist, das mit der Aufnehmerelektrode (14) verbunden ist, wobei die Bedieneinheit (12) zumindest ein Bedienmittel (20), das als ein Drehelement ausgebildet ist, aufweist, das dazu vorgesehen ist, an der Platteneinheit (16) angeordnet zu sein und die Aufnehmerelektrode (14) zu betätigen, wobei die Aufnehmerelektrode (14) dazu vorgesehen ist, zumindest ein Signal aufzunehmen und das aufgenommene Signal an das Sensorelement (18) weiterzuleiten, und wobei das Signal als eine Kapazitätsänderung ausgebildet ist, und wobei das Sensorelement (18) zu der Aufnehmerelektrode (14) beabstandet angeordnet ist, wobei das Bedienmittel (20) zumindest teilweise abnehmbar an der Platteneinheit (16) angeordnet ist, wobei die Bedieneinheit (12) eine Vielzahl an Aufnehmerelektroden (14) aufweist, die zumindest im Wesentlichen in einer Linie angeordnet sind, und wobei die Bedieneinheit (12) eine Vielzahl an Sensorelementen (18) aufweist, die jeweils einer der Aufnehmerelektroden (14) zugeordnet sind, wobei jeder der Aufnehmerelektroden (14) eines der Sensorelemente (18) zugeordnet ist, wobei die Bedieneinheit (12) zumindest eine Steuereinheit (40) aufweist, die dazu vorgesehen ist, in Abhängigkeit von einer Betätigung einer der Aufnehmerelektroden (14) zumindest eine von dem Bediener durch die Betätigung der einen Aufnehmerelektrode (14) gewünschte Aktion auszuführen, wobei die Sensorelemente (18) dazu vorgesehen sind, das bei Betätigung der mit dem Sensorelement (18) verbundenen Aufnehmerelektrode (14) detektierte Signal zumindest an die Steuereinheit (40) zu übertragen, **dadurch gekennzeichnet, dass** zumindest die Aufnehmerelektroden (14) als Beschichtung ausgebildet sind, wobei die Beschichtung auf der Rückseite der Platteneinheit (16) aufgebracht ist.

2. Kochfeld nach Anspruch 1, **dadurch gekennzeichnet, dass** das Bedienmittel (20) zumindest ein Betätigungselement (22) zu einer Betätigung der Aufnehmerelektrode (14) aufweist, das an der Rückseite der Platteneinheit (16) angeordnet ist.

3. Kochfeld nach einem der vorhergehenden Ansprüche, **dadurch gekennzeichnet, dass** die Linie zumindest im Wesentlichen einen Kreis ausbildet.

4. Kochfeld nach einem der vorhergehenden Ansprüche, **dadurch gekennzeichnet, dass** die Bedieneinheit (12) zumindest ein Abschirmelement (26) aufweist, das dazu vorgesehen ist, zumindest das Sensorelement (18) abzuschirmen.

## Claims

1. Hob with a plate unit (16) embodied as a hob plate for a placement of cookware and with at least one hob operating apparatus, which has at least one operating unit (12), which has at least one transducer electrode (14), which is arranged on a rear side of the plate unit (16), and at least one sensor element (18), which is connected to the transducer electrode (14), wherein the operating unit (12) has at least one operating means (20), which is embodied as a rotary element and which is provided to be arranged on the plate unit (16) and to actuate the transducer electrode (14), wherein the transducer electrode (14) is provided to record at least one signal and to forward the recorded signal to the sensor element (18), and wherein the signal is embodied as a change in capacitance, and wherein the sensor element (18) is arranged at a distance from the transducer electrode (14), wherein the operating means (20) is arranged in an at least partially removable manner on the plate unit (16), wherein the operating unit (12) has a large number of transducer electrodes (14), which are arranged at least substantially in a line, and wherein the operating unit (12) has a large number of sensor elements (18), each of which is allocated to one of the transducer electrodes (14), wherein each of the transducer electrodes (14) is allocated one of the sensor elements (18), wherein the operating unit (12) has at least one control unit (40), which is provided, as a function of an actuation of one of the transducer electrodes (14), to carry out at least one action desired by the operator by actuating the one transducer electrode (14), wherein the sensor elements (18) are provided to transmit the signal, which is detected on actuation of the transducer electrode (14) connected to the sensor element (18), at least to the control unit (40), **characterised in that** at least the transducer electrodes (14) are embodied as a coating, wherein the coating is applied to the rear side of the plate unit (16).

2. Hob according to claim 1, **characterised in that** the operating means (20) has at least one actuating element (22) for actuating the transducer electrode (14), which actuating element (22) is arranged on the rear side of the plate unit (16).

3. Hob according to one of the preceding claims, **characterised in that** the line at least substantially forms a circle.

4. Hob according to one of the preceding claims, **characterised in that** the operating unit (12) has at least one shielding element (26), which is provided to shield at least the sensor element (18).

## Revendications

1. Table de cuisson avec une unité de plaque (16) configurée comme une plaque de table de cuisson pour le placement de récipients de cuisson et avec au moins un dispositif de commande de la table de cuisson, lequel comporte au moins une unité de commande (12), qui présente au moins une électrode captrice (14), disposée sur un côté arrière de l'unité de plaque (16) et présente au moins un élément détecteur (18), raccordé à l'électrode captrice (14), cette unité de commande (12) comportant au moins un moyen de commande (20) réalisé sous forme d'élément rotatif prévu pour être agencé à l'unité de plaque (16) et pour actionner l'électrode captrice (14), cette électrode captrice (14) étant prévue pour recevoir au moins un signal et pour transférer ce signal reçu à l'élément détecteur (18), et le signal étant réalisé comme une modification de capacité, et cet élément détecteur (18) étant disposé écarté de l'électrode captrice (14), le moyen de commande (20) étant disposé au moins en partie escamotable sur l'unité de plaque (16), l'unité de commande (12) présentant une pluralité d'électrodes captrices (14), agencées au moins essentiellement en une ligne, et l'unité de commande (12) comportant une pluralité d'éléments détecteurs (18), associés chacun à une des électrodes captrices (14), chacune des électrodes captrices (14) étant associée à l'un des éléments détecteurs (18), l'unité de commande (12) présentant au moins une unité de guidage (40) prévue pour, en fonction de l'actionnement d'une des électrodes captrices (14), exécuter au moins une action souhaitée par l'opérateur par l'actionnement d'une électrode captrice (14), les éléments détecteurs (18) étant prévus pour transmettre le signal détecté en cas d'actionnement de l'électrode captrice (14) raccordée à l'élément détecteur (18), au moins à l'unité de guidage (40), **caractérisée en ce qu'**au moins les électrodes captrices (14) sont réalisées sous forme de revêtement, ce revêtement étant appliqué sur le côté arrière de l'unité de plaque (16).

2. Table de cuisson selon la revendication 1, **caractérisée en ce que** le moyen de commande (20) comporte au moins un élément d'actionnement (22) pour l'actionnement de l'électrode captrice (14), lequel est agencé sur le côté arrière de l'unité de plaque (16).

3. Table de cuisson selon l'une des revendications précédentes, **caractérisée en ce que** la ligne forme au moins essentiellement un cercle.

4. Table de cuisson selon l'une des revendications précédentes, **caractérisée en ce que** l'unité de commande (12) comporte au moins un élément de protection (26) prévu pour protéger au moins l'élément détecteur.
